Europäisches Patentamt

European Patent Office

Office européen des brevets

(19)

(11) Numéro de publication : **0 407 286 B1**

(12) **FASCICULE DE BREVET EUROPEEN**

(45) Date de publication du fascicule du brevet :
30.03.94 Bulletin 94/13

(51) Int. Cl.$^5$ : **C30B 25/00, C30B 29/36**

(21) Numéro de dépôt : **90401909.8**

(22) Date de dépôt : **02.07.90**

(54) Procédé de préparation de fibres monocristallines de carbure de silicium.

(30) Priorité : **06.07.89 FR 8909115**

(43) Date de publication de la demande :
**09.01.91 Bulletin 91/02**

(45) Mention de la délivrance du brevet :
**30.03.94 Bulletin 94/13**

(84) Etats contractants désignés :
**AT BE CH DE DK ES FR GB GR IT LI LU NL SE**

(56) Documents cités :
**EP-A- 0 170 362**
**EP-A- 0 272 773**
**EP-A- 0 280 630**
**FR-A- 2 522 024**
**US-A- 3 840 647**
**US-A- 4 283 375**
**US-A- 4 504 453**
**US-A- 4 789 536**

(73) Titulaire : **ELF ATOCHEM S.A.**
**4 & 8, Cours Michelet La Défense 10**
**F-92800 Puteaux (FR)**

(72) Inventeur : **Disson, Jean-Pierre**
**5 Rue Jules Ferry**
**F-38500 Voiron (FR)**
Inventeur : **Bachelard, Roland**
**99 Grande Rue de la Guillotière**
**F-69007 Lyon (FR)**

(74) Mandataire : **Rochet, Michel et al**
**ELF ATOCHEM S.A. Département Propriété**
**Industrielle 4-8, Cours Michelet La Défense 10**
**- Cedex 42**
**F-92091 Paris-La-Défense (FR)**

Jouve, 18, rue Saint-Denis, 75001 PARIS

# Description

L'invention a pour objet un procédé de préparation de fibres monocristallines de carbure de silicium.

La fabrication de fibres monocristallines ou trichites (en anglais : whiskers) de carbure de silicium a donné lieu à une abondante littérature. Une technique fréquemment rencontrée consiste à préparer ces fibres monocristallines à partir de silice, de carbone et d'un catalyseur métallique, notamment du fer, selon le procédé V.L.S. (phase vapeur-catalyseur liquide-croissance du whisker à l'état solide cristallisé). L'exposé de cette technique se trouve décrit par exemple par MILEWSKI et al. dans Journal of Materials Science 20 (1985) pp. 1160-1166. Dans cet article, on utilise un support graphitique revêtu de catalyseur et, dans un réacteur contenant ce catalyseur supporté et des plaques poreuses impregnées de silice et de carbone, on envoie un courant gazeux comprenant du méthane, de l'hydrogène, de l'oxyde de carbone et de l'azote. On obtient, selon les conditions de la réaction, des whiskers dont le diamètre peut aller de 1 à 8 µm et une longueur pouvant aller de 10 à 20 mm, l'utilisation d'une faible quantité d'azote [inférieure à 9 % pour 80 % d'hydrogène, le complément à 100 % étant formé par CO (10 %), SiO (0,5 %) et $CH_4$ (0,5 %)] conduisant de préférence à des whiskers sphériques ou maclés ou ramifiés [op. cit. page 1165].

Dans le brevet français n° 2592399, on propose de fabriquer les trichites de carbure de silicium en faisant appel à un catalyseur préallié formé à partir d'un catalyseur métallique, de carbone et de silicium ou d'un mélange de carbone et de silicium. Selon ce document, on applique ce catalyseur préallié à un substrat de carbone, on chauffe l'ensemble en atmosphère réductrice, on introduit dans cette atmosphère des gaz contenant du silicium et du carbone, on maintient le débit de ces gaz en conservant une température suffisante pour provoquer la croissance des trichites et enfin, on refroidit les trichites.

Le brevet français n° 2573444 s'intéresse tout particulièrement aux qualités du noir de carbone et à leur incidence sur les propriétés des fibres obtenues dans un procédé consistant à mélanger une source de silicium avec le noir de carbone et à chauffer ce mélange en atmosphère non oxydante.

Dans le brevet français n° 2522024, on propose de mélanger un gel de silice, un composé soluble dans l'eau d'au moins un métal (fer, nickel ou cobalt) et un noir de carbone spécifique, et de chauffer ce mélange entre 1300 et 1700 °C dans une atmosphère non-oxydante. Ce brevet recommande l'addition de chlorure de sodium pour améliorer l'allongement des cristaux de whiskers. Les cristaux obtenus (β-SiC) ont un diamètre compris entre 0,2 et 0,5 µm et une longueur comprise entre 200 et 300 µm.

Dans le brevet français n° 2574775, on expose à de l'azote gazeux des balles de céréales prétraitées par un acide et calcinées puis on retire le nitrure de silicium formé, on ajoute au carbone restant du silicium et du carbone et on chauffe l'ensemble en atmosphère non-oxydante, de façon à obtenir les whiskers de carbure de silicium.

Dans le brevet européen n° 0179670, on forme du carbure de silicium à partir de silice, de poudre de carbone et d'un catalyseur métallique du type niobium, tantale et leurs mélanges. La réaction s'effectue entre 1400 et 1900°C.

Dans le brevet européen n° 0272773, on moule préalablement le produit contenant du silicium en une forme prédéterminée puis on le chauffe avec du carbone entre 1400 et 1700° dans une atmosphère contenant au moins 70 % d'hydrogène. Cette atmosphère peut également contenir de l'azote. On obtient des whiskers dont le diamètre peut aller de 0,1 à 0,5 µm, la longueur de 50 à 400 µm et le rapport d'aspect de 500 à 800.

Dans le brevet français n° 2097792, on propose de faire passer un courant d'hydrogène contenant un halogène d'abord sur du silicium métallique en poudre porté à 1100-1550°C puis à faire passer le gaz contenant du silicium sur du charbon pulvérulent chauffé à 1100-1550°C puis enfin à faire croître les whiskers sur un substrat.

Dans le brevet français n° 2150393, on utilise un substrat recouvert de graphite et du silicium en poudre et on fait croître les whiskers à partir d'une phase gazeuse contenant de l'hydrogène, de l'azote, un hydrocarbure et un hydracide halogéné.

L'invention concerne un procédé de fabrication de fibres monocristallines de carbure de silicium de variété β, par carboréduction de silice ($SiO_2$), ce procédé étant caractérisé en ce qu'il consiste :

A/ à préparer une pâte à partir de silice, de noir de carbone, d'un catalyseur métallique et d'un liant générant du carbone

B/ à former des granulés à partir de cette pâte

C/ à provoquer le durcissement du liant et l'obtention de granulés poreux

D/ à mettre ces granulés en contact avec une atmosphère comprenant de l'hydrogène et de l'azote et/ou un composé de l'azote à une température au moins égale à 1150°C jusqu'à transformation d'au moins 95 % de la silice en carbure de silicium.

On complète avantageusement les étapes précédentes en :

E/ éliminant éventuellement le carbone excédentaire

F/ éliminant le catalyseur et/ou le métal ex-catalyseur.

Par composé de l'azote, on désigne tout particulièrement l'ammoniac et les oxydes d'azote ($N_2O$, NO, $NO_2$), l'invention s'appliquant à l'emploi aussi bien d'un de ces composés que d'un mélange desdits produits.

La silice mise en oeuvre dans ce procédé peut consister en silice amorphe sous forme de particules dont au moins 50 % en poids présente un diamètre compris entre 1 et 2,5 μm. On peut également utiliser des silices cristallisées pouvant se présenter sous forme de particules ou de fibres. La surface spécifique (BET) de la silice est avantageusement supérieure à 20 m²/g. De préférence, la surface spécifique de la silice est comprise entre 250 m²/g et 1000 m²/g.

Bien que le composé silicié puisse n'être constitué que par de la silice et notamment la silice définie ci-avant sous ses formes recommandées, on ne sortirait pas du cadre de l'invention en ajoutant à la silice une faible proportion, par exemple inférieure à 10 % en poids (exprimé en Si) de silicium métallique et/ou d'un autre composé silicié.

Le noir de carbone présente avantageusement une surface spécifique BET d'au moins 50 m²/g et de préférence d'au moins 100 m²/g et se présente sous forme d'aggrégats de particules élémentaires dont au moins 50 % en poids présente un diamètre compris entre 0,5 et 2,5 μm. On donne la préférence au noir de carbone dont le volume poreux (méthode déterminée par porosimètrie au mercure) est supérieur à 1 cm³/g et de préférence supérieur à 5 cm³/g, la valeur maximum ne dépassant généralement pas 12 cm³/g.

Le noir de carbone peut être choisi parmi les différents produits relevant de cette appellation et résultant généralement de la combustion ou de la dissociation thermique de substances hydrocarbonées, telles que le gaz naturel, l'acetylène, les huiles minérales, les huiles de goudron. Parmi ces différents noirs de carbone, on retiendra tout particulièrement le noir d'acétylène, le noir thermique, le noir au four, le noir obtenu par procédé Tunnel.

Dans le procédé conforme à l'invention, on utilise avantageusement la silice et le noir de carbone dans un rapport molaire $\frac{Si}{C}$ compris entre 1:3,5 et 1:15, compte tenu du carbone apporté par le liant utilisé dans la préparation de la pâte.

Le catalyseur métallique peut être avantageusement choisi dans le groupe constitué par le fer, le nickel et le cobalt et les composés en dérivant, notamment leurs oxydes, nitrates, chlorures, sulfates, carbonates ainsi que les alliages contenant au moins un de ces métaux.

Bien qu'il soit possible de mettre en oeuvre le catalyseur, sous forme de solution notamment aqueuse, on donne la préférence à des poudres dont la granulométrie est inférieure à 50 μm et de préférence inférieure à 20 μm.

D'une manière générale, on utilise 0,01 à 0,8 et de préférence 0,02 à 0,2 mole de catalyseur par mole de SiO₂.

Le liant générant du carbone peut être choisi dans une très grande famille de substances naturelles ou synthétiques se transformant en carbone lors de la réaction de carboréduction de SiO₂. Parmi ces substances, on citera notamment les goudrons de houille, les résines ou polymères notamment thermodurcissables tels que les résines phénoliques, par exemple résines phénolformol, les résines epoxy, les polyimides, les polyurées, les polycarbonates.

Le liant est utilisé en quantité suffisante pour former une pâte homogène renfermant la silice et le noir de carbone. A titre purement indicatif, cette quantité peut être de l'ordre de 5 à 25 g de liant pour 100 g de mélange silice + noir de carbone.

En fonction de son état physique (solide, pâteux, liquide), le liant peut, le cas échéant, être mis en oeuvre sous forme de solution ou dispersion. Une technique particulièrement simple consiste à utiliser une solution aqueuse par exemple de résine phénolformol. La pâte précitée peut être obtenue par simple malaxage de ses constituants à température ambiante.

Dans le procédé conforme à l'invention, la pâte comprenant la silice, le carbone, le catalyseur et le liant est mise sous forme de granulés, par pastillage, sphérulisation ou encore par extrusion de ladite pâte et découpage et/ou broyage du jonc sortant de l'extrudeuse. Les granulés peuvent se présenter sous forme de pastilles, cylindres ou plus généralement de particules à forme régulière ou irrégulière. D'une manière générale, la plus grande dimension de ces granulés est supérieure à 0,2 mm et, de préférence, est comprise entre 1 et 30 mm, ces valeurs n'étant données qu'à titre indicatif.

Les granulés ainsi formés sont avantageusement portés à une température pouvant aller de 50 à 250°C dans le but d'obtenir un durcissement et/ou une polymérisation du liant et, le cas échéant, l'élimination de l'eau.

Par action notamment sur la quantité de liant et/ou sur les conditions de durcissement et séchage éventuel des granulés, on obtient des granulés dont le volume poreux peut aller de 0,1 à 3 cm³/g constituant un autre objet de l'invention.

Les granulés précités sont mis en contact avec une atmosphère comprenant de l'hydrogène et de l'azote et/ou un composé de l'azote. D'une manière générale, cette atmosphère comprend au moins 70 et de préférence au moins 95 % en volume d'hydrogène et au moins 0,1 % d'azote et/ou de composé de l'azote, l'éventuel complément à 100 % pouvant être obtenu par exemple par utilisation d'argon et/ou de monoxyde de carbone. De préférence, on utilise au moins 0,5 % d'azote et/ou de composé de l'azote.

D'une manière générale, la carboréduction peut, dans le procédé conforme à l'invention, commencer dès une température relativement basse (par comparaison avec l'enseignement habituel de la littérature), c'est-à-dire de l'ordre de 1150°C. En général, la mise en contact des granulés avec l'atmosphère contenant H₂ et N₂ et/ou composé de l'azote s'effectue à basse température (température ambiante), la température étant élevée progressivement ou en plusieurs étapes jusqu'à 1100 à 1500°C puis maintenue à cette température jusqu'à fin de la réaction de transformation de la silice en carbure de silicium. L'élévation progressive de la température peut se faire en 1 à 5 heures, le maintien subséquent à la température ainsi obtenue pouvant également durer quelques heures, par exemple 2 à 10 heures, ces valeurs de durée n'étant données qu'à titre purement indicatif.

Il va sans dire qu'on a indiqué ci-avant des valeurs de 1150-1500°C pour la température de carboréduction pour montrer que, dans le procédé conforme à l'invention, cette réaction se produit dès cette température mais qu'on peut bien entendu procéder à plus haute température, par exemple jusqu'à 1600-1700°C.

Dans la mesure où on a utilisé, du fait de la quantité de noir de carbone et de liant générant du carbone, un excès de carbone par rapport à la stoechéométrie de la réaction, on peut éliminer le carbone excédentaire, par exemple par chauffage à l'air à une température avantageusement supérieure à 600°C. Il peut être également souhaitable d'éliminer les particules de catalyseur métallique et/ou de métal issu de ce catalyseur, par exemple par traitement acide.

Les exemples suivants illustrent l'invention.

## EXEMPLE 1

22 g de poudre de silice amorphe ($S_{BET}$ = 600 m²/g, $d_{50}$ = 1,7 µm, perte au feu à 1000°C = 18 %) sont mélangés dans un malaxeur en Z à 36 g de noir d'acétylène ($S_{BET}$ = 110 m²/g, $d_{50}$ = 1,7 µm, volume poreux = 11 cm³/g) et 0,9 g de poudre de fer de granulométrie inférieure à 10 µm. On incorpore au mélange 6,5 g d'une résine formophénolique et 100 g d'eau, toutes ces opérations étant effectuées à 25°C. Après environ deux heures de malaxage, on obtient une pâte qu'on extrude sous forme de petits cylindres de 6 mm de diamètre. Par chauffage à 150°C, on élimine l'eau et provoque le durcissement de la résine. La porosité au mercure des granulés ainsi obtenus est de l'ordre de 1,4 cm³/g.

9,2 g de granulés séchés sont introduits dans un creuset en graphite dont le fond est percé de trous permettant le passage des gaz. Un courant gazeux, composé de 97 % d'hydrogène et 3 % d'azote (en volume) percole à travers les granulés. La température est portée à 1290°C en deux heures et maintenue à cette valeur pendant cinq heures. La perte en poids, mesurée après refroidissement naturel du four, indique le taux de transformation de 100 % de la silice en carbure de silicium.

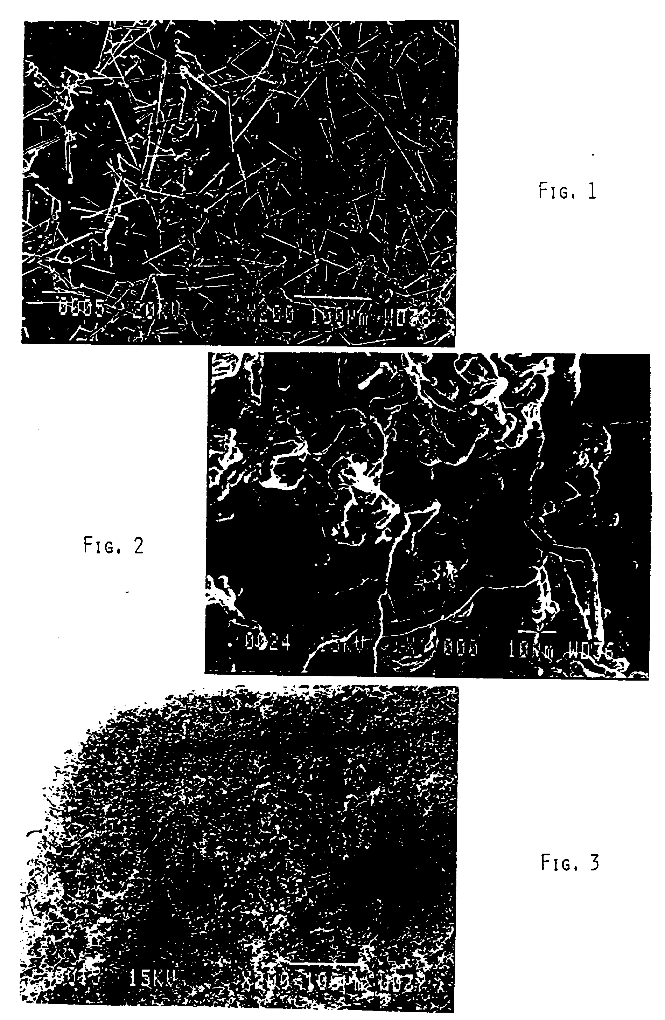

Les granulés sont ensuite placés dans une nacelle en alumine, et le carbone excédentaire éliminé par chauffage à l'air à 700°C environ pendant 3 h. Un traitement au moyen d'acide permet ensuite d'éliminer les particules de catalyseur. A l'issue de ces opérations, on obtient 1,9 g de fibres de carbure de silicium de variété cristalline β (détermination par diffraction des rayons X), comme illustrées à la figure 1. Leur diamètre moyen est d'environ 2 à 3 µm, la longueur moyenne est d'environ 70 µm et le rapport d'aspect est d'environ 50 (moyenne).

L'expression rapport d'aspect, couramment utilisée dans la technologie des fibres monocristallines désigne le rapport $\frac{longueur}{diamètre}$.

## EXEMPLE 2

On procède comme pour l'exemple 1, mais le palier de température est remplacé par une montée de 25°C à 1150°C en 1 h 30 mn, suivie d'une montée en 7 h à 1430°C. L'essai est arrêté une fois cette température atteinte. On obtient, avec un rendement de 100 %, des fibres dont les caractéristiques sont similaires à celles des fibres de l'exemple 1.

## EXEMPLE 3

On procède comme dans l'exemple 1, mais l'atmosphère gazeuse est constituée de 94 % d'hydrogène et 6 % d'ammoniac. La température du palier, maintenue pendant 5 h et atteinte en 2 h, est de 1380°C. Dans ces conditions, on obtient avec un rendement de 96 % des fibres de caractéristiques similaires à celles des fibres de l'exemple 1.

## EXEMPLES COMPARATIFS

### Exemple C1

On procède comme dans l'exemple 1, mais avec injection d'hydrogène seul au lieu de $H_2$ + $N_2$. La température est élevée en deux heures jusqu'à 1280°C et maintenue pendant 5 h à cette valeur. On obtient, avec un rendement voisin de 100 %, des fibres tordues et maclées, comme illustrées sur la figure 2.

### Exemple C2

On procède comme dans l'exemple 1, mais l'azote est remplacée par un courant de gaz inerte (3 % d'argon). On obtient avec un rendement de 100 % des fibres tordues et maclées analogues à celles de l'exemple C1.

### Exemple C3

On procède comme pour l'exemple 1, mais l'atmosphère gazeuse est constituée d'argon (99 %) et méthane (1 %). On porte la température à 1350°C en deux heures, et on la maintient à cette valeur pendant cinq heures. Le rendement est environ de 80 % en SiC. On ne trouve pratiquement pas de fibres dans le produit, qui est essentiellement de la poudre.

Exemple C4

48,5 g de noir d'acétylène, 2,9 g de poudre de fer et 8,6 g de la résine formophénolique de l'exemple 1 sont mélangés dans un mélangeur en Z. On ajoute de l'eau en quantité nécessaire pour obtenir une pâte d'une consistance convenable pour extrusion. Après extrusion en diamètre 6 mm, ces granulés sont chauffés à 150°C pour éliminer l'eau et durcir la résine.
Par ailleurs, 40 g de silice, 8 g de résine formophénolique et de l'eau en quantité nécessaire pour l'extrudabilité sont mélangés au malaxeur en Z. La pâte est ensuite extrudée en diamètre 6 mm et les granulés obtenus sont séchés à 105°C.
4,7 g de granulés contenant la silice et 5,2 g de granulés contenant le noir d'acétylène et le catalyseur sont introduits (après mélange entre les granulés) dans un creuset en graphite. Le creuset est placé dans la zone centrale d'un four tubulaire, et balayé par un courant d'hydrogène. La température est portée à 1470°C en deux heures et maintenue à cette valeur pendant 5 heures. Après refroidissement, la perte en poids indique un taux de transformation proche de 100 %. On constate que les granulés à base de silice ont entièrement disparu. Les granulés à base de carbone sont recouverts d'une croûte de SiC contenant quelques fibres. Ils sont transférés dans une nacelle d'alumine et chauffés à l'air à environ 700°C pour éliminer le carbone. On récupère alors des croûtes de SiC de forme cylindrique ayant un diamètre voisin du diamètre initial des extrudats. Elles sont composées essentiellement d'un bloc de SiC et de quelques fibres de part et d'autre de ce bloc, comme illustré sur la figure 3).

**Revendications**

1. Procédé de fabrication de fibres monocristallines de carbure de silicium de variété β, par carboréduction de silice ($SiO_2$), ce procédé étant caractérisé en ce qu'il consiste :
    A/ à préparer une pâte à partir de silice, de noir de carbone, d'un catalyseur métallique et d'un liant générant du carbone
    B/ à former des granulés à partir de cette pâte
    C/ à provoquer le durcissement du liant et l'obtention de granulés poreux
    D/ à mettre ces granulés en contact avec une atmosphère comprenant de l'hydrogène et de l'azote et/ou un composé de l'azote à une température au moins égale à 1150°C jusqu'à transformation d'au moins 95 % de la silice en carbure de silicium

2. Procédé selon la revendication 1 caractérisé en ce qu'il comprend les phases supplémentaires d'élimination du carbone excédentaire éventuellement présent et l'élimination du catalyseur et/ou du métal ex-catalyseur.

3. Procédé selon l'une quelconque des revendications 1 et 2, caractérisé en ce que la silice est une silice amorphe de surface spécifique (BET) supérieure à 20 m²/g.

4. Procédé selon l'une quelconque des revendications 1 à 3, caractérisé en ce que le noir de carbone présente une surface spécifique d'au moins 50 m²/g.

5. Procédé selon l'une quelconque des revendications 1 à 4, caractérisé en ce que le noir de carbone est du noir d'acétylène.

6. Procédé selon l'une quelconque des revendications 1 à 5, caractérisé en ce que le catalyseur est choisi dans le groupe constitué par le fer, le nickel, le cobalt et leurs dérivés, notamment leurs oxydes, nitrates, chlorures, sulfates et carbonates, et présente une granulométrie inférieure à 50 μm.

7. Procédé selon l'une quelconque des revendications 1 à 6, caractérisé en ce que le liant générant du carbone est choisi dans le groupe constitué par le goudron de houille et les résines phénoliques, epoxy, les polyimides, les polyurées et les polycarbonates.

8. Procédé selon l'une quelconque des revendications 1 à 7, caractérisé en ce que le liant est utilisé en quantité suffisante pour former une pâte homogène comprenant la silice le noir de carbone et le catalyseur métallique.

9. Procédé selon l'une quelconque des revendications 1 à 8, caractérisé en ce que les granulés sont portés à une température comprise entre 50 et 250°C pour obtenir le durcissement et/ou la polymérisation du liant.

10. Procédé selon l'une quelconque des revendications 1 à 9, caractérisé en ce que l'atmosphère avec laquelle les granulés sont mis en contact est constituée d'au moins 70 % en volume d'hydrogène et au moins 0,1 % d'azote et/ou d'ammoniac.

11. Procédé selon l'une quelconque des revendications 1 à 10, caractérisé en ce que la carboréduction est effectuée à une température comprise entre 1150 et 1500°C, avec paliers éventuels à ces ou entre ces températures.

12. Procédé selon la revendication 2, caractérisé en ce que le carbone excédentaire est éliminé par chauffage à l'air des fibres à une température supérieure à 600°C.

13. Procédé selon la revendication 2, caractérisé en ce que le catalyseur est éliminé par traitement acide.

14. Granulés formés à partir de la pâte selon l'une quelconque des revendications 1 à 13 comprenant la silice, le noir de carbone, le catalyseur et le liant et dont le volume poreux est compris entre 0,1 et 3 cm³/g.

**Patentansprüche**

1. Verfahren zur Herstellung von monokristallinen β-Siliciumcarbidfasern durch Kohlenstoffreduktion von Siliciumdioxid (SiO₂), dadurch gekennzeichnet, daß es folgende Schritte umfaßt:
   A) Herstellung einer Paste aus Siliciumdioxid, Ruß, Metallkatalysator und einem Kohlenstoff bildenden Bindemittel.
   B) Herstellung eines Granulats aus dieser Paste.
   C) Einleitung des Härtungsprozesses des Bindemittels und Gewinnung eines porösen Granulats.
   D) Einbringen dieses Granulats in eine Atmosphäre aus Wasserstoff und Stickstoff und-/oder einer Stickstoffverbindung bei einer Temperatur von mindestens 1150°C, bis zur Umsetzung von mindestens 95 % des Siliciumdioxids in Siliciumcarbid.

2. Verfahren nach Anspruch 1, dadurch gekennzeichnet, daß es weitere Schritte zur Entfernung von eventuell vorhandenem überschüssigen Kohlenstoff sowie zur Entfernung des Katalysators und/oder des Metalls aus dem Katalysator enthält.

3. Verfahren nach einem der Ansprüche 1 oder 2, dadurch gekennzeichnet, daß das Siliciumdioxid ein amorphes Siliciumdioxid mit einer spezifischen Oberfläche (BET) von mehr als 20 m²/g ist.

4. Verfahren nach einem der Ansprüche 1 bis 3, dadurch gekennzeichnet, daß der Ruß eine spezifische Oberfläche von mindestens 50 m²/g hat.

5. Verfahren nach einem der Ansprüche 1 bis 4, dadurch gekennzeichnet, daß der Ruß Acetylenruß ist.

6. Verfahren nach einem der Ansprüche 1 bis 5, dadurch gekennzeichnet, daß der Katalysator aus der Gruppe von Eisen, Nickel, Cobalt und ihren Verbindungen, vorzugsweise ihrer Oxide, Nitrate, Chloride, Sulfate und Carbonate ausgewählt ist, und eine Korngröße kleiner 50 μm hat.

7. Verfahren nach einem der Ansprüche 1 bis 6, dadurch gekennzeichnet, daß das verkohlende Bindemittel aus der Gruppe von Steinkohlenteer, Phenolharzen, Epoxidharz, Polyimiden, Polycarbamiden und Polycarbonaten ist.

8. Verfahren nach einem der Ansprüche 1 bis 7, dadurch gekennzeichnet, daß das Bindemittel in einer ausreichenden Menge verwendet wird, um eine homogene Siliciumdioxid, Ruß und Metallkatalysator enthaltende Paste zu bilden.

9. Verfahren nach einem der Ansprüche 1 bis 8, dadurch gekennzeichnet, daß das Granulat auf eine Temperatur zwischen 50 und 250°C gebracht wird, um eine Härtung und/oder Polymerisation des Bindemittels zu erhalten.

10. Verfahren nach einem der Ansprüche 1 bis 9, dadurch gekennzeichnet, daß die Atmosphäre, mit der das Granulat in Kontakt gebracht wird, aus mindestens 70 Vol.% Wasserstoff und mindestens 0,1 % Stickstoff und/oder Ammoniak besteht.

11. Verfahren nach einem der Ansprüche 1 bis 10, dadurch gekennzeichnet, daß die Reduktion mittels Kohlenstoff bei einer Temperatur zwischen 1150 und 1500°C erfolgt, mit eventuellen Stufen bei oder zwischen diesen Temperaturen.

12. Verfahren nach Anspruch 2, dadurch gekennzeichnet, daß überschüssiger Kohlenstoff durch Erhitzen der Fasern an Luft auf eine Temperatur über 600°C entfernt wird.

13. Verfahren nach Anspruch 2, dadurch gekennzeichnet, daß der Katalysator durch Behandlung mit Säure entfernt wird.

14. Granulat, geformt aus einer Paste aus Siliciumdioxid, Ruß, Katalysator und Bindemittel gemäß einem der Ansprüche 1 bis 13, dessen Porenvolumen zwischen 0,1 und 3 cm³/g liegt.

**Claims**

1. Process for the manufacture of monocrystalline silicon carbide fibres of β variety by carboreduction of silica (SiO₂), this process being characterized in that it consists:

A/ in preparing a paste from silica, carbon black, a metal catalyst and a binder generating carbon

B/ in forming granules from this paste

C/ in causing the hardening of the binder and the obtaining of porous granules

D/ in placing these granules in contact with an atmosphere comprising hydrogen and nitrogen and/or a nitrogen compound at a temperature of at least 1150°C until at least 95 % of the silica has been converted into silicon carbide.

2. Process according to Claim 1, characterized in that it comprises the additional stages of removal of the excess carbon which may be present and of the removal of the catalyst and/or of the ex-catalyst metal.

3. Process according to either of Claims 1 and 2, characterized in that the silica is an amorphous silica with a specific surface (BET) greater than 20 m²/g.

4. Process according to any one of Claims 1 to 3, characterized in that the carbon black has a specific surface of at least 50 m²/g.

5. Process according to any one of Claims 1 to 4, characterized in that the carbon black is acetylene black.

6. Process according to any one of Claims 1 to 5, characterized in that the catalyst is chosen from the group consisting of iron, nickel, cobalt and their dérivatives, especially their oxides, nitrates, chlorides, sulphates and carbonates, and has a particle size lower than 50 µm.

7. Process according to any one of Claims 1 to 6, characterized in that the binder generating carbon is chosen from the group consisting of coal tar and phenolic or epoxy resins, polyimides, polyureas and polycarbonates.

8. Process according to any one of Claims 1 to 7, characterized in that the binder is employed in sufficient quantity to form a homogeneous paste comprising silica, carbon black and the metal catalyst.

9. Process according to any one of Claims 1 to 8, characterized in that the granules are heated to a temperature of between 50 and 250°C to obtain the curing and/or the polymerization of the binder.

10. Process according to any one of Claims 1 to 9, characterized in that the atmosphere with which the granules are placed in contact consists of at least 70 % by volume of hydrogen and at least 0.1 % of nitrogen and/or ammonia.

11. Process according to any one of Claims 1 to 10, characterized in that the carboreduction is carried out at a temperature of between 1150 and 1500°C, with optional plateaus at these or between these temperatures.

12. Process according to Claim 2, characterized in that the excess carbon is removed by heating the fibres in air to a temperature higher than 600°C.

13. Process according to Claim 2, characterized in that the catalyst is removed by acid treatment.

14. Granules formed from the paste according to any one of Claims 1 to 13, comprising silica, carbon black, the catalyst and the binder and whose pore volume is between 0.1 and 3 cm³/g.

FIG. 1

FIG. 2

FIG. 3